# FASCICULE DE BREVET EUROPEEN

(11) **EP 2 457 105 B1**
(45) Date de publication et mention de la délivrance du brevet: **27.04.2016**
(21) Numéro de dépôt: 10734237.0
(22) Date de dépôt: 04.06.2010
(51) Int. Cl.: G01R 31/00, G01R 31/327

(54) **PROCÉDÉ DE DIAGNOSTIC DU FONCTIONNEMENT D'UN DISPOSITIF DE COUPURE ET DE RACCORDEMENT D'UNE BATTERIE A UN RÉSEAU DE BORD DE VÉHICULE AUTOMOBILE**
DIAGNOSEVERFAHREN FÜR DEN BETRIEB EINER VORRICHTUNG ZUM ABTRENNEN UND ANSCHLIESSEN EINER BATTTERIE VON EINEM BORDSTROMNETZ EINES KRAFTFAHRZEUGES
METHOD FOR DIAGNOSING THE OPERATION OF A DEVICE FOR CUTTING OFF AND CONNECTING A BATTERY FROM/TO THE ONBOARD POWER NETWORK OF A MOTOR VEHICLE

(30) Priorité: 24.07.2009 FR 0955218
(43) Date de publication de la demande: 30.05.2012
(73) Titulaire: Renault S.A.S., 92100 Boulogne-Billancourt (FR)
(72) Inventeur: BOIRON, Daniel, F-78960 Voisins Le Bretonneux (FR); ORIGUCHI, Masato, F-78120 Rambouillet (FR)
(86) Numéro de dépôt international: PCT/FR2010/051110
(87) Numéro de publication internationale: WO 2011/010026

(56) Documents cités:
- JP-A- 2009 071 898

## Description

### DOMAINE DE L'INVENTION

L'invention a trait au domaine de l'alimentation de réseau de bord de véhicule automobile à une batterie d'accumulateurs, et plus particulièrement au diagnostic de l'état de fonctionnement des relais assurant la coupure et le raccordement bipolaire du réseau de bord et de la batterie.

### ETAT DE LA TECHNIQUE

Dans un véhicule automobile électrique ou hybride, la batterie d'accumulateurs fournit une tension élevée, classiquement supérieure à 60V, à un réseau de bord haute tension du véhicule, à savoir l'ensemble des consommateurs d'électricité alimentés par la batterie. En raison de la tension élevée fournie par la batterie, la coupure de celle-ci, par exemple lorsque le véhicule passe dans un mode parking, doit être bipolaire, c'est-à-dire que les deux bornes de la batterie doivent être déconnectées du réseau de bord. Une telle coupure bipolaire de la batterie permet en effet :
▪ d'isoler automatiquement le réseau de bord haute tension de la batterie en cas d'incident technique susceptible d'endommager les composants du réseau de bord ou de nuire à la sécurité des utilisateurs du véhicule ;
▪ d'éviter en mode parking la décharge de la batterie par des courants de fuite ; et
▪ de limiter la durée d'application de la haute tension au réseau de bord à la seule durée d'utilisation effective de la batterie, et ainsi améliorer la durée de vie des composants du réseau de bord qui subissent à minima la haute tension et les contraintes électriques associées, y compris en cas de défaillance simple des composants assurant cette coupure.

La coupure bipolaire de la batterie doit par ailleurs satisfaire à des contraintes électriques pour préserver à la fois les composants mettant en oeuvre ladite coupure et les composants du réseau de bord, notamment en ce qui concerne les phases transitoires de raccordement et de coupure. Plus particulièrement, il convient :
▪ de limiter le courant lors de la coupure et du raccordement de la batterie au réseau de bord afin de ne pas stresser les composants de celui-ci, comme des condensateurs par exemple, et de ne pas stresser les composants de coupure et de raccordement eux-mêmes ;
▪ diagnostiquer l'état de fonctionnement des composants de coupure et de raccordement, classiquement des relais de puissance, et ainsi éviter toute propagation de la panne de ceux-ci vers le réseau de bord ;
▪ minimiser le nombre de commande des composants de coupure et de raccordement, classiquement des relais de puissance, afin d'optimiser leur durée de vie, notamment celle des contacts des relais ; et
▪ de permettre de mesure la tension de la batterie haute tension à courant nul afin notamment d'estimer l'état de charge de celle-ci comme cela est nécessaire dans la gestion d'une batterie de véhicule électrique ou hybride.

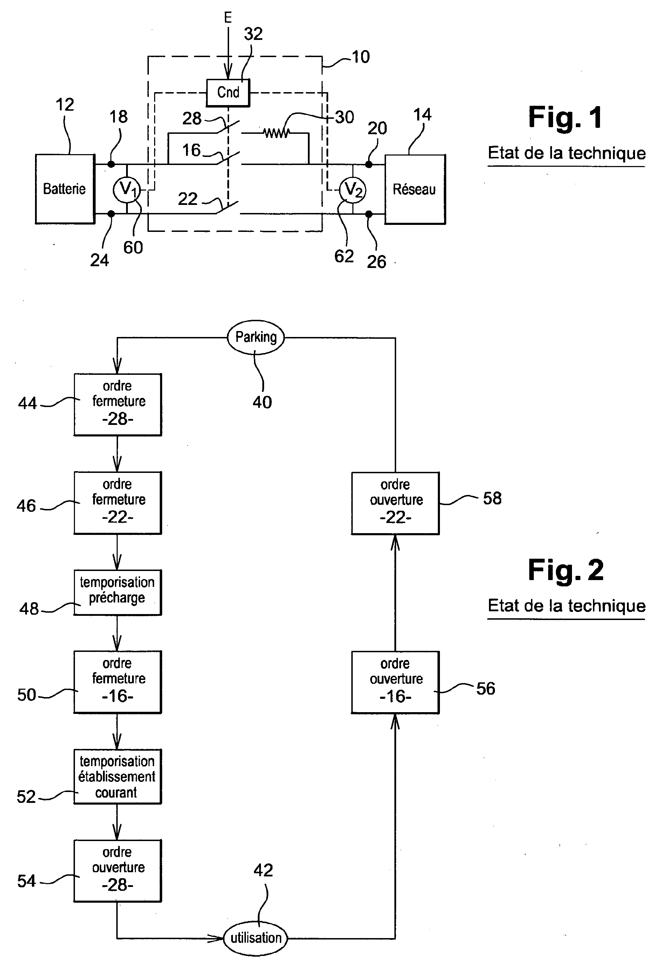

La figure 1 est une vue schématique d'un organe 10 de l'état de la technique de coupure et de raccordement entre une batterie d'accumulateurs haute tension 12 et un réseau de bord haute tension 14, conçu en vue de satisfaire les conditions décrites ci-dessus.

L'organe 10 de coupure et de raccordement comporte :
▪ un premier relais de puissance 16 connecté entre une première borne 18 de la batterie 12 et une première borne 20 du réseau 14 ;
▪ un deuxième relais de puissance 22, connecté entre la seconde borne 24 de la batterie et la seconde borne 26 du réseau ;
▪ une ligne de précharge comportant un troisième relais 28 et une résistance 30 connectés en série entre les premières bornes 18, 20 de la batterie et du réseau ; et
▪ un module de commande 32 pilotant l'ouverture et la fermeture des relais 16, 22, 28 selon des séquences prédéterminées, comme cela est expliqué ci-après.

La figure 2 est un organigramme illustrant les séquences d'ouverture et de fermeture des relais 16, 22, 28 mis en oeuvre par le module de commande 32 permettant de passer de véhicule du mode parking (lorsque la batterie 12 est coupée du réseau de bord 14) au mode utilisation (lorsque la batterie 12 est raccordée au réseau de bord 14).

Pour passer du mode parking 40, dans lequel les trois relais 16, 22, 28 sont ouverts, au mode utilisation 42 dans lequel les premiers et deuxième relais 16, 22 sont fermés et le troisième relais 28 ouvert, un ordre de fermeture du troisième relais 28 est tout d'abord produit en 44 par le module 32, puis celui-ci ordonne la fermeture du deuxième relais 22 en 46. Une temporisation est alors activée en 48 pour laisser le temps à la précharge du réseau de bord 14 de se terminer.

Une fois le réseau de bord préchargé, le module 32 ordonne, en 50, au premier relais 16 de se fermer, puis une temporisation est activée en 52 pour laisser le temps au courant de s'établir dans le réseau de bord 14, cette temporisation étant notamment supérieure à la durée des rebonds du premier relais 16. Une fois le courant établi dans le réseau de bord, le module 32 en 54 produit un ordre d'ouverture du troisième relais 28, le véhicule se trouvant alors dans le mode utilisation 42.

Pour passer du mode utilisation 42 au mode parking 40, le module 32 émet tout d'abord en 56 un ordre d'ouverture du premier relais 16, puis un ordre d'ouverture du deuxième relais 22 en 58.

Les séquences venant d'êtres décrites pour passer d'un mode de fonctionnement à un autre sont celles qui minimisent le nombre d'ouverture et de fermeture des relais. Elles sont donc en pratique privilégiées pour préserver les relais 16, 22, 28 et ainsi optimiser leur durée de vie.

En se référant de nouveau à la figure 1, classiquement pour diagnostiquer une défaillance du dispositif 10 de coupure et de raccordement, dont un relais peut par exemple rester bloqué dans son état ouvert ou fermé, un premier voltmètre 60 (figure 1) est agencé entre les bornes 18, 24 de la batterie 12 et un second voltmètre 62 est agencé entre les bornes 20, 26 du réseau de bord 14, les voltmètres 60, 62 étant par exemple connectés au module de commande 32 qui met en oeuvre un diagnostic en fonction des tensions mesurées par ceux-ci.

Si le traitement des tensions mesurées permet effectivement de diagnostiquer certaines défaillances, comme par exemple le blocage du premier relais 16 dans son état fermé lorsque les tensions mesurées par le premier et le deuxième voltmètres 60, 62 sont égales à la tension aux bornes de la batterie 12 (mesurée par le premier voltmètre 60 lorsque le véhicule est en mode parking) à la suite d'un ordre d'ouverture du premier relais 16 (étape 56 de la séquence de coupure de la batterie), il n'est cependant pas possible de diagnostiquer à temps certaines défaillances. Plus particulièrement, lorsque le deuxième relais 22 est bloqué dans son état fermé, cette défaillance ne peut être diagnostiquée que lorsque le véhicule passe du mode parking au démarrage. De fait, la coupure bipolaire de la batterie 12 peut ne pas avoir lieu pendant une longue période (période passée en mode parking) avant que cette défaillance ne soit détectée, ce qui peut être dommageable à la fois pour la batterie 12 et le réseau de bord 14 pour les raisons évoquées ci-dessus.

Le document JP 2009 071 898 décrit une charge de commande pour mécanisme de stockage et son procédé de commande.

### EXPOSE DE L'INVENTION

Le but de la présente invention est de résoudre le problème susmentionné en proposant un procédé de diagnostic de l'état de fonctionnement des relais du dispositif de coupure et de raccordement qui permette de déterminer les défaillances affectant la coupure bipolaire de la batterie, avec un minimum de mesure et sans modifier les séquences d'ouverture et de fermeture desdits relais.

A cet effet, l'invention a pour objet un procédé de diagnostic de l'état de fonctionnement d'un dispositif de coupure et de raccordement d'une batterie d'accumulateurs haute tension bipolaire à un réseau de bord bipolaire de véhicule automobile, ledit dispositif comportant un premier relais de puissance agencé entre une première borne de la batterie et une première borne du réseau, un deuxième relais de puissance agencé entre une seconde borne de la batterie et une seconde borne du réseau, et un agencement série d'un troisième relais de précharge et d'une résistance de précharge, connecté en parallèle du premier relais de puissance, ledit procédé comportant :
▪ la mesure de deux tensions du dispositif de coupure et de raccordement ;
▪ la comparaison des tensions mesurées avec des valeurs de tension prédéterminées représentatives de défaillances du dispositif de coupure et de raccordement ; et
▪ le diagnostic d'une défaillance d'un relais en fonction du résultat de la comparaison.

Selon l'invention, les tensions mesurées sont une première tension entre la première borne de la batterie et la borne du deuxième relais agencée côté réseau de bord et une seconde tension entre les première et seconde bornes du réseau de bord.

En d'autres termes, ces tensions comprennent ensemble les informations nécessaires au diagnostic des défaillances impactant la coupure bipolaire de la batterie sans que le véhicule soit nécessairement dans le mode parking.

Selon des modes de réalisation particuliers de l'invention, le procédé comporte une ou plusieurs des caractéristiques suivantes :
▪ en cours d'utilisation du véhicule par le conducteur :
   ∘ le raccordement de la batterie au réseau de bord consiste consécutivement en la fermeture du deuxième relais, la fermeture du troisième relais, la fermeture du premier relais et l'ouverture du troisième relais ;
   ∘ la coupure de la batterie du réseau de bord consiste consécutivement en l'ouverture du premier relais et l'ouverture du deuxième relais, et le premier relais est diagnostiqué comme présentant un état continuellement fermé si après un ordre d'ouverture de celui-ci, les première et seconde tension mesurées sont sensiblement égales à la tension à vide de la batterie,
▪ en cours d'utilisation du véhicule par le conducteur :
   ∘ le raccordement de la batterie au réseau de bord consiste consécutivement en la fermeture du deuxième relais, la fermeture du troisième relais, la fermeture du premier relais et l'ouverture du troisième relais ;
   ∘ la coupure de la batterie du réseau de bord consiste consécutivement en l'ouverture du premier relais et l'ouverture du deuxième relais,
   et le deuxième relais est diagnostiqué comme présentant un état continuellement fermé si après un ordre d'ouverture de celui-ci, la première tensions mesurée est sensiblement égale à la tension à vide de la batterie et la seconde tension mesurée est sensiblement nulle,
▪ en cours d'utilisation du véhicule par le conductc-ur :
   o le raccordement de la batterie au réseau de bord consiste consécutivement en la fermeture du deuxième relais, la fermeture du troisième relais, la fermeture du premier relais et l'ouverture du troisième relais ;
   o la coupure de la batterie du réseau de bord consiste consécutivement en l'ouverture du premier relais et l'ouverture du deuxième relais,
   et le troisième relais est diagnostiqué comme présentant un état continuellement fermé si après un ordre d'ouverture du premier relais, la première tension mesurée est sensiblement égale à la tension à vide de la batterie et la seconde tension est positive et inférieure à la tension à vide de la batterie,
▪ en cours d'utilisation du véhicule par le conducteur :
   ∘ le raccordement de la batterie au réseau de bord consiste consécutivement en la fermeture du deuxième relais, la fermeture du troisième relais, la fermeture du premier relais et l'ouverture du troisième relais ;
   o la coupure de la batterie du réseau de bord consiste consécutivement en l'ouverture du premier relais et l'ouverture du deuxième relais,
   et le premier relais est diagnostiqué comme présentant un état continuellement ouvert si après un ordre d'ouverture du troisième relais, la première tension mesurée est sensiblement égale à la tension à vide de la batterie et si la seconde tension mesurée décroit,
▪ en cours d'utilisation du véhicule par le conducteur :
   ∘ le raccordement de la batterie au réseau de bord consiste consécutivement en la fermeture du deuxième relais, la fermeture du troisième relais, la fermeture du premier relais et l'ouverture du troisième relais ;
   ∘ la coupure de la batterie du réseau de bord consiste consécutivement en l'ouverture du premier relais et l'ouverture du deuxième relais,
   et le troisième relais est diagnostiqué comme présentant un état continuellement ouvert si après un ordre d'ouverture de fermeture de celui-ci relais, la première tension mesurée est sensiblement égale à la tension à vide de la batterie et si la seconde tension mesurée est sensiblement nulle,
▪ en cours d'utilisation du véhicule par le conducteur :
   ∘ le raccordement de la batterie au réseau de bord consiste consécutivement en la fermeture du deuxième relais, la fermeture du troisième relais, la fermeture du premier relais et l'ouverture du troisième relais ;
   ∘ la coupure de la batterie du réseau de bord consiste consécutivement en l'ouverture du premier relais et l'ouverture du deuxième relais,
   et le deuxième relais est diagnostiqué comme présentant un état continuellement ouvert ou bien les bornes de la batterie sont diagnostiquées en circuit ouvert si après un ordre de fermeture du deuxième relais, la première et la seconde tensions mesurées sont sensiblement nulles,
▪ une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et le deuxième relais est diagnostiqué comme étant continuellement fermé si, dans le mode parking, la première tension mesurée est sensiblement égale à la tension à vide de la batterie et la seconde tension mesurée est sensiblement nulle,
▪ une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et le deuxième relais est diagnostiqué comme étant continuellement ouvert ou bien les bornes de la batterie sont diagnostiquées comme étant en circuit ouvert si après un ordre de fermeture du deuxième relais, les première et deuxième tensions mesurées sont sensiblement nulles,
▪ le procédé comporte en outre la mesure de la tension aux bornes du deuxième relais pour savoir qui des bornes de la batterie ou du deuxième relais est en circuit ouvert,
▪ une séquence de maintenance du véhicule consiste consécutivement, depuis un mode de parking dans lequel les premiers, deuxièmes et troisièmes relais sont ouvertes, en la fermeture du deuxième relais, la fermeture du troisième relais, la fermeture du premier relais, l'ouverture du troisième relais, l'ouverture du premier relais et l'ouverture du deuxième relais, et le troisième relais est diagnostiqué comme étant continuellement fermé si après un ordre de fermeture du deuxième relais, la première tension mesurée est sensiblement égale à la tension à vide de la batterie et la seconde tension mesurée croit jusqu'à la tension à vide de la batterie,
▪ une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais, et le troisième relais est diagnostiqué comme étant continuellement ouvert si après un ordre de fermeture du troisième relais, la première tension mesurée est sensiblement égale à la tension à vide de la batterie et la seconde tension mesurée est sensiblement nulle,
▪ une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et le premier relais est diagnostiqué comme étant continuellement ouvert si après un ordre d'ouverture du troisième relais, la première tension mesurée est sensiblement égal à la tension à vide de la batterie et la seconde tension mesurée décroit.

### BREVE DESCRIPTION DES FIGURES

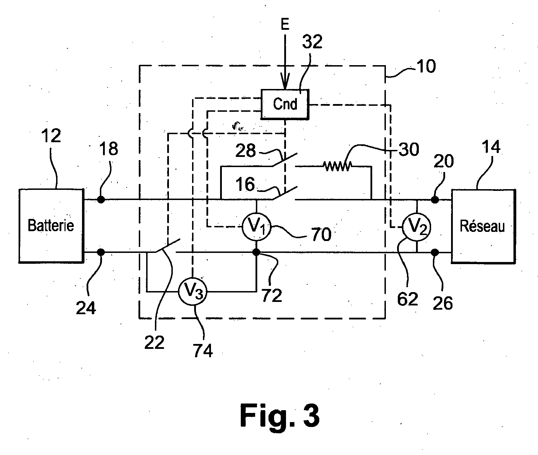

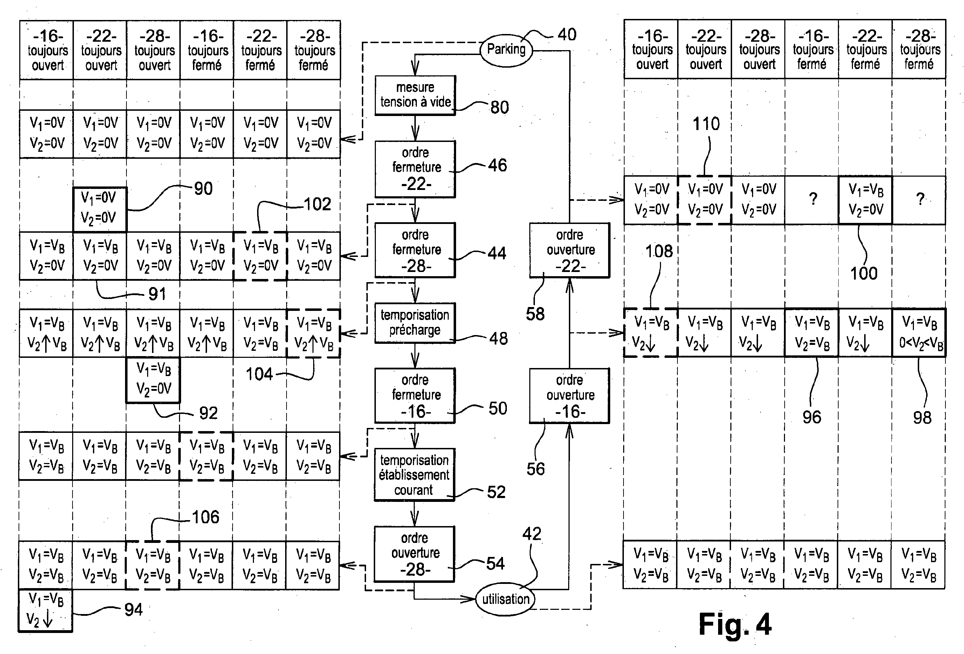

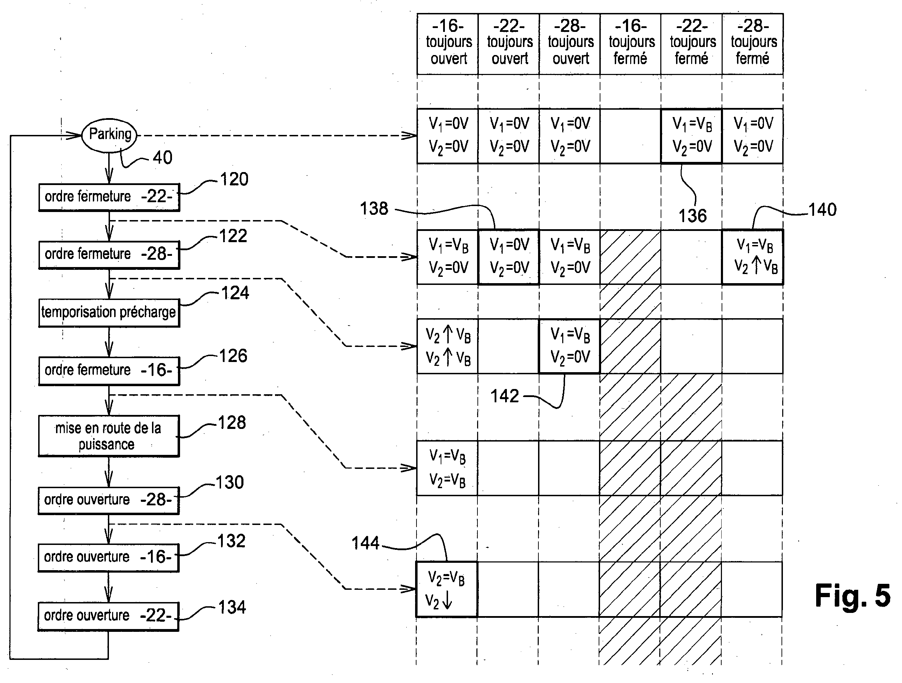

L'invention sera mieux comprise à la lecture de la description qui va suivre, donnée uniquement à titre d'exemple, et faite en relation avec les dessins annexés, dans lesquels des références identiques désignent des éléments identiques ou analogues, et dans lesquels :
▪ la figure 1 est une vue schématique d'un dispositif de l'état de la technique de coupure et de raccordement d'une batterie à un réseau de bord de véhicule automobile, décrite dans le préambule ;
▪ la figure 2 est un organigramme des séquences d'ouverture et de fermeture du dispositif de la figure 1, décrit dans le préambule ;
▪ la figure 3 est une vue schématique illustrant les mesures de tension selon l'invention ;
▪ la figure 4 est un organigramme des séquences d'ouverture et de fermeture des relais associé à un tableau de diagnostic des défaillances selon l'invention en fonction des mesures de tension illustrées à la figure 3 ; et
▪ la figure 5 est un organigramme d'une séquence de fermeture et d'ouverture de maintenance du véhicule automobile associé à un tableau de diagnostic des défaillance selon l'invention en fonction des mesures de tension illustrées à la figure 3.

### DESCRIPTION DETAILLEE DE L'INVENTION

La figure 3 illustre les mesures de tension réalisées selon l'invention, le dispositif de coupure et de raccordement 10 de la batterie 12 au réseau de bord 14 étant identique à celui de la figure 1.

Selon l'invention, une première mesure de tension est réalisée par voltmètre 70 entre la première borne 18 de la batterie 12 et la seconde borne 26 du réseau de bord, c'est-à-dire entre la première borne 18 de la batterie et la borne 72 du deuxième relais 22 agencé du côté réseau de bord 14. Une deuxième mesure de tension est par ailleurs réalisée par un voltmètre 62 entre les bornes 20, 26 du réseau de bord. Enfin de manière optionnelle, une troisième mesure de tension est réalisée par un voltmètre 74 aux bornes du deuxième relais 22.

La figure 4 est un organigramme illustrant les séquences d'ouverture et de fermeture des relais 16, 22, 28 mis en oeuvre par le module de commande 32 permettant de passer de véhicule du mode parking au mode utilisation. Selon l'invention, les séquences d'ouverture et de fermeture diffèrent de celles décrites en relation avec la figure 2 en ce que les ordres de fermetures 46, 44 des deuxième et troisième relais 22, 28 sont inversés. Par ailleurs, une étape 80 de mesure de la tension à vide V_{B} de la batterie 12, c'est-à-dire la tension aux bornes 18, 24 de celle-ci lorsque lesdites bornes sont en circuit ouvert comme cela est le cas dans le mode parking, est prévue avant la séquence de fermeture des relais pour le passage en mode utilisation.

Sur la figure 4, il est également illustré les valeurs que prennent, après chaque ordre d'ouverture ou de fermeture du module de commande 32, la tension V₁, mesurée par le premier voltmètre 70, et la tension V₂, mesurée par le deuxième voltmètre 62, en présence de défaillances des relais 16, 22, 28, à savoir le premier relais 16 bloqué en position ouverte, ou le deuxième relais 22 bloqué en position ouverte, ou le troisième relais 28 bloqué en position ouverte, ou le premier relais 16 bloqué en position fermé, ou le deuxième relais 22 bloqué en position fermée, ou le troisième relais bloqué 28 en position fermée. Le symbole «↑» symbolise une tension croissante et le symbole «↓» symbolise une tension décroissante. Ainsi par exemple, l'expression «V₁ ↓ V_{B}» signifie que la tension V₁ décroit jusqu'à la valeur V_{B}. Par ailleurs pour un même état d'ouverture et de fermeture des relais, les tensions V₁ et V₂ peuvent parfois prendre des valeurs différentes, ce qui est symbolisé par deux blocs agencées l'un au dessus de l'autre, comme par exemple les blocs 90 et 91.

A l'aide des tensions V₁ et V₂ mesurée et la comparaison de celles-ci avec valeurs représentatives de défaillances prédéterminées des relais 16, 22, 28 du dispositif de coupure et de raccordement, le module de commande 32 diagnostique lesdites défaillances.

Plus particuliérement :
▪ lorsqu'à la suite de l'ordre de fermeture du deuxième interrupteur 22 en 46, les tensions V₁ et V₂ sont sensiblement nulles (bloc 90), le module 32 diagnostique que le deuxième relais 22 est bloqué dans son état ouvert ou que les bornes de la batterie 12 sont en circuit ouvert ;
▪ lorsqu'à la suite de l'ordre de fermeture du troisième relais 28 en 44, la tension V₁ est sensiblement égale à la tension V_{B} et la tension V₂ est sensiblement nulle (bloc 92), le module 32 diagnostique que le troisième relais 28 est bloqué dans son état ouvert ;
▪ lorsqu'à la suite de l'ordre d'ouverture du troisième relais 28 en 54, la tension V₁ est sensiblement égale à la tension V_{B} et la tension V₂ décroit (bloc 94), le module 32 diagnostique que le premier relais 16 est bloqué dans son état ouvert ;
▪ lorsqu'à la suite de l'ordre d'ouverture du premier relais 16 en 56, les tensions V₁ et V₂ sont sensiblement égales à la tension V_{B} (bloc 96), le module 32 diagnostique que le premier relais 16 est bloqué dans son état fermé.
▪ lorsqu'à la suite de l'ordre d'ouverture du premier relais 16 en 56, la tension V₁ est sensiblement égale à la tension V_{B} et la tension V₂ est comprise entre 0 et V₃ (bloc 98), le module 32 diagnostique que le troisième relais 28 est bloqué dans son état fermé ;
▪ lorsqu'à la suite de l'ordre d'ouverture du deuxième relais 22 en 58, la tension V₁ est sensiblement égale à la tension V_{B} et la tension V₂ est sensiblement nulle (bloc 100), le module 32 diagnostique que le deuxième relais 22 est bloqué dans son état fermé.

Comme on peut le constater les défaillances des relais sont détectés au plus tôt avant même l'entrée en mode parking du véhicule. Ainsi par exemple lors de la séquence d'ouverture pour la mise en mode parking du véhicule, si les tensions V₁ et V₂ sont sensiblement égale, alors le premier relais 16 est bloqué dans son état fermé et si la tension V₂ est inférieure à la tension V₁ alors le troisième relais 28 est bloqué dans son état fermé.

Dans le cas où il serait nécessaire de distinguer qui du deuxième relais 22 est dans son état ouvert ou des bornes de la batterie 12 est en circuit ouvert (bloc 90), la mesure de tension par le troisième voltmètre 74 permet de lever cette incertitude.

Par ailleurs, il est possible de déterminer de manière plus précoce qu'une défaillance est apparue dans le dispositif de coupure et de raccordement 10, sans pour autant déterminer exactement la nature de ladite défaillance.

Plus particulièrement, une défaillance du module 10 est diagnostiquée, sans qu'à ce stade ladite défaillance ait un effet fonctionnel et donc critique sur le fonctionnement de celui-ci ou des composants du réseau de bord :
▪ lorsqu'à la suite de l'ordre de fermeture du deuxième relais 22 en 46, la tension V₁ est sensiblement égale à la tension V_{B} et la tension V₂ est sensiblement nulle (bloc 102);
▪ lorsqu'à la suite de l'ordre de fermeture du troisième relais 28 en 44, la tension V₁ est sensiblement égale à la tension V_{B} et la tension V₂ croit jusqu'à la tension V_{B} (bloc 104) ;
▪ lorsqu'à la suite de l'ordre d'ouverture du troisième relais 28 en 54, les tensions V₁ et V₂ sont sensiblement égales à la tension V_{B} (bloc 106) ;
▪ lorsqu'à la suite de l'ordre d'ouverture du premier relais 16 en 56, la tension V₁ est sensiblement égale à la tension V_{B} et la tension V₂ décroit (bloc 108) ;
▪ lorsqu'à la suite de l'ordre d'ouverture du deuxième relais 22 en 56, les tensions V₁ et V₂ sont sensiblement nulles (bloc 110).

Lorsqu'une défaillance du dispositif de coupure et de raccordement 10 est diagnostiquée, le conducteur du véhicule en est averti, par exemple au moyen de l'allumage d'un voyant lumineux du tableau de bord du véhicule, invitant celui-ci à se procéder à une réparation ou un changement du dispositif de coupure et de raccordement 10.

Une fois chez le réparateur, une séquence d'ouverture et de fermeture des relais 16, 22, 28, dite de « maintenance », peut être mise en oeuvre pour reproduire la défaillance d'un relais qui a été détectée lors de l'utilisation du véhicule par le conducteur et ainsi confirmer ce diagnostic et une fois la réparation intervenue, vérifer que la défaillance a disparu.

Une telle séquence de maintenance est illustrée à la figure 5 en association des valeurs que prennent les tensions mesurées V₁ et V₂ lors de défaillances des relais 16, 22, 28.

Depuis le mode parking 40, un ordre de fermeture du deuxième relais 22 est produit en 120 suivi d'un ordre de fermeture du troisième relais 28 en 122. Une fois une temporisation de précharge mise en oeuvre en 124, la séquence de maintenance se poursuit en 126 par un ordre de fermeture du premier relais 126 puis la puissance électrique est mise en route en 128 de sorte que la batterie 12 soit raccordée au réseau de bord 14 pour alimenter la chaine de traction électrique du véhicule. Un ordre d'ouverture du troisième relais 28 est alors produit en 130, suivi d'un ordre d'ouverture du premier relais 16 en 132 et d'un ordre d'ouverture du deuxième relais 22 en 134. Le véhicule retourne alors dans son mode parking 40.

Le module de commande 32 met alors en oeuvre le diagnostic suivant :
▪ dans le mode parking 40, si la tension V₁ est sensiblement égale à la tension V_{B} et la tension V₂ est sensiblement nulle (bloc 136), le module 32 diagnostique alors que le troisième relais 28 est bloqué dans son état fermé ;
▪ lorsqu'à la suite de l'ordre de fermeture du deuxième relais 22 en 120, les tensions V₁ et V₂ sont sensiblement nulles (bloc 138), le module 32 diagnostique que le deuxième relais 22 est bloqué dans son état ouvert ou bien que les bornes de la batterie 12 sont en circuit ouvert, l'incertitude sur la défaillance étant optionnellement levée par l'exploitation de la mesure de la tension aux bornes du deuxième relais 22 par le voltmètre 74 ;
▪ lorsqu'à la suite de l'ordre de fermeture du deuxième relais 22 en 120, la tension V₁ est sensiblement égale à la tension V_{B} et la tension V₂ croit jusqu'à la tension V_{B} (bloc 140), le module 32 diagnostique que le troisième relais 28 est bloqué dans son état fermé ;
▪ lorsqu'à la suite de l'ordre de fermeture du troisième relais 28 en 122, la tension V₁ est sensiblement égale à la tension V_{B} et la tension V₂ est sensiblement nulle (bloc 142), le module 32 diagnostique que le troisième relais 28 est bloqué dans son état ouvert ; et
▪ lorsqu'à la suite de l'ordre d'ouverture du troisième relais 28 en 130, la tension V₁ est sensiblement égal à la tension V_{B} et la tension V₂ décroit (bloc 144), le module 32 diagnostique que le premier relais 16 est bloqué dans son état ouvert.

Par ailleurs lorsque le premier relais 16 a été diagnostiqué comme bloqué dans son état fermé, par exemple lors de l'utilisation du véhicule par le conducteur, comme décrit en relation avec la figure 4, la séquence de maintenance constituée des étapes 120 à 134 est de préférence interdite. En effet, une telle séquence avec le premier relais 16 bloqué dans son état fermé provoquerait une charge rapide du réseau de bord 14, ce qui risquerait d'endommager d'autres relais et les composants du réseau de bord 14. Pour les mêmes raisons, la séquence constituée des étapes 126 à 134 est interdite lorsque le second relais 22 est bloqué dans son état fermé.

Ces interdictions peuvent par exemple être gérés par le module de commande 32 qui garde en mémoire les défaillances diagnostiquées et inhibe par défaut les séquences dangereuses pour les différents composants et relais.

Grâce à l'invention, il est ainsi obtenu un diagnostic du fonctionnement du dispositif de coupure et de raccordement permettant de détecter au plutôt, et particulièrement avant l'entrée du véhicule dans son mode parking, les défaillances des relais constitutifs de celui-ci. En outre, ce diagnostic n'ajoute aucune étape supplémentaire d'ouverture ou de fermeture desdites relais, préservant ainsi leur durée de vie.

## Revendications

1. Procédé de diagnostic de l'état de fonctionnement d'un dispositif (10) de coupure et de raccordement d'une batterie d'accumulateurs haute tension bipolaire (12) à un réseau de bord bipolaire (14) de véhicule automobile, ledit dispositif (10) comportant un premier relais de puissance (16) agencé entre une première borne (18) de la batterie (12) et une première borne (20) du réseau (14), un deuxième relais de puissance (22) agencé entre une seconde borne (24) de la batterie (12) et une seconde borne (26) du réseau (14), et un agencement série (28, 30) d'un troisième relais de précharge (28) et d'une résistance de précharge (30), connecté en parallèle du premier relais de puissance (16), ledit procédé comportant :
▪ la mesure de deux tensions (V₁, V₂) du dispositif (10) de coupure racéordement ;
▪ la comparaison des tensions mesurées (V₁, V₂) avec des valeurs de tension prédéterminées représentatives de défaillances du dispositif (10) de coupure et de raccordement ; et
▪ le diagnostic d'une défaillance d'un relais (16, 22, 28) en fonction du résultat de la comparaison,
***caractérisé* en ce que** les tensions mesurées sont une première tension (V₁) entre la première borne (18) de la batterie (12) et la borne du deuxième relais (22) agencée côté réseau de bord (14) et une seconde tension (V₂) entre les première et seconde bornes (20, 26) du réseau de bord (14).

2. Procédé selon la revendication 1, ***caractérisé* en ce que**, en cours d'utilisation du véhicule par le conducteur :
▪ le raccordement de la batterie au réseau de bord consiste consécutivement en la fermeture du deuxième relais, la fermeture du troisième relais, la fermeture du premier relais et l'ouverture du troisième relais ;
▪ la coupure de la batterie du réseau de bord consiste consécutivement en l'ouverture du premier relais et l'ouverture du deuxième relais,
et ce que le premier relais est diagnostiqué comme présentant un état continuellement fermé si après un ordre d'ouverture de celui-ci, les première et seconde tensions mesurées sont sensiblement égales à la tension à vide de la batterie.

3. Procédé selon la revendication 1 ou 2, ***caractérisé* en ce que**, en cours d'utilisation du véhicule par le conducteur :
▪ le raccordement de la batterie au réseau de bord consiste consécutivement en la fermeture du deuxième relais, la fermeture du troisième relais, la fermeture du premier relais et l'ouverture du troisième relais ;
▪ la coupure de la batterie du réseau de bord consiste consécutivement en l'ouverture du premier relais et l'ouverture du deuxième relais,
et ce que le deuxième relais est diagnostiqué comme présentant un état continuellement fermé si après un ordre d'ouverture de celui-ci, la première tensions mesurées est sensiblement égale à la tension à vide de la batterie et la seconde tension mesurée est sensiblement nulle.

4. Procédé selon la revendication 1, 2 ou 3, ***caractérisé* en ce que**, en cours d'utilisation du véhicule par le conducteur:
▪ le raccordement de la batterie au réseau de bord consiste consécutivement en la fermeture du deuxième relais, la fermeture du troisième relais, la fermeture du premier relais et l'ouverture du troisième relais ;
▪ la coupure de la batterie du réseau de bord consiste consécutivement en l'ouverture du premier relais et l'ouverture du deuxième relais,
et ce que le troisième relais est diagnostiqué comme présentant un état continuellement fermé si après un ordre d'ouverture du premier relais, la première tension mesurée est sensiblement égale à la tension à vide de la batterie et la seconde tension est positive et inférieure à la tension à vide de la batterie.

5. Procédé selon l'une quelconque des revendications précédentes, ***caractérisé* en ce que**, en cours d'utilisation du véhicule par le conducteur :
▪ le raccordement de la batterie au réseau de bord consiste consécutivement en la fermeture du deuxième relais, ta fermeture du troisième relais, la fermeture du premier relais et l'ouverture du troisième relais ;
▪ la coupure de la batterie du réseau de bord consiste consécutivement en l'ouverture du premier relais et l'ouverture du deuxième relais,
et ce que le premier relais est diagnostiqué comme présentant un état continuellement ouvert si après un ordre d'ouverture du troisième relais, la première tension mesurée est sensiblement égale à la tension à vide de la batterie et si la seconde tension mesurée décroit.

6. Procédé selon l'une quelconque des revendications précédentes, ***caractérisé* en ce que**, en cours d'utilisation du véhicule par le conducteur :
▪ le raccordement de la batterie au réseau de bord consiste consécutivement en la fermeture du deuxième relais, la fermeture du troisième relais, la fermeture du premier relais et l'ouverture du troisième relais ;
▪ la coupure de la batterie du réseau de bord consiste consécutivement en l'ouverture du premier relais et l'ouverture du deuxième relais,
et ce que le troisième relais est diagnostiqué comme présentant un état continuellement ouvert si après un ordre d'ouverture de fermeture de celui-ci relais, la première tension mesurée est sensiblement égale à la tension à vide de la batterie et si la seconde tension mesurée est sensiblement nulle.

7. Procédé selon l'une quelconque des revendications précédentes, ***caractérisé* en ce que**, en cours d'utilisation du véhicule par le conducteur :
▪ le raccordement de la batterie au réseau de bord consiste consécutivement en la fermeture du deuxième relais, la fermeture du troisième relais, la fermeture du premier relais et l'ouverture du troisième relais ;
▪ coupure de la batterie du réseau de bord consiste consécutivement en l'ouverture du premier relais et l'ouverture du deuxième relais,
et ce que le deuxième relais est diagnostiqué comme présentant un état continuellement ouvert ou bien les bornes de la batterie sont diagnostiquées en circuit ouvert si après un ordre de fermeture du deuxième relais, la première et la seconde tensions mesurées sont sensiblement nulles.

8. Procédé selon l'une quelconque des revendications précédentes, ***caractérisé* en ce qu'**une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et **en ce que** le deuxième relais est diagnostiqué comme étant continuellement fermé si, dans le mode parking, la première tension mesurée est sensiblement égale à la tension à vide de la batterie et la seconde tension mesurée est sensiblement nulle,

9. Procédé selon l'une quelconque des revendications précédentes, ***caractérisé* en ce qu'**une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et **en ce que** le deuxième relais est diagnostiqué comme étant continuellement ouvert ou bien les bornes de la batterie sont diagnostiquées comme étant en circuit ouvert si après un ordre de fermeture du deuxième relais, les première et deuxième tensions mesurées sont sensiblement nulles.

10. Procédé selon la revendication 9, ***caractérisé* en ce qu'**il comporte en outre la mesure de la tension aux bornes du deuxième relais pour savoir qui des bornes de la batterie ou du deuxième relais est en circuit ouvert.

11. Procédé selon l'une quelconque des revendications précédentes, ***caractérisé* en ce qu'**une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et **en ce que** le troisième relais est diagnostiqué comme étant continuellement fermé si après un ordre de fermeture du deuxième relais, la première tension mesurée est sensiblement égale à la tension à vide de la batterie et la seconde tension mesurée croit jusqu'à la tension à vide de la batterie.

12. Procédé selon l'une quelconque des revendications précédentes, ***caractérisé* en ce qu'**une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais, et **en ce que** le troisième relais est diagnostiqué comme étant continuellement ouvert si après un ordre de fermeture du troisième relais, la première tension mesurée est sensiblement égale à la tension à vide de la batterie et la seconde tension mesurée est sensiblement nulle.

13. Procédé selon l'une quelconque des revendications précédentes, ***caractérisé* en ce qu'**une séquence de maintenance du véhicule consiste consécutivement, depuis un mode de parking dans lequel les premiers, deuxièmes et troisièmes relais sont ouverts, en la fermeture du deuxième relais, la fermeture du troisième relais, la fermeture du premier relais, l'ouverture du troisième relais, l'ouverture du premier relais et l'ouverture du deuxième relais, et **en ce que** le premier relais est diagnostiqué comme étant continuellement ouvert si après un ordre d'ouverture du troisième relais, la première tension mesurée est sensiblement égal à la tension à vide de la batterie et la seconde tension mesurée décroit.

## Patentansprüche

1. Verfahren zur Diagnose des Betriebszustands einer Vorrichtung (10) zum Abschalten und Anschließen einer bipolaren Hochspannungs-Akkumulatorenbatterie (12) an ein bipolares Bordnetz (14) eines Kraftfahrzeugs, wobei die Vorrichtung (10) ein erstes Leistungsrelais (16), das zwischen einer ersten Klemme (18) der Batterie (12) und einer ersten Klemme (20) des Netzes (14) angeordnet ist, ein zweites Leistungsrelais (22), das zwischen einer zweiten Klemme (24) der Batterie (12) und einer zweiten Klemme (26) des Netzes (14) angeordnet ist, und eine Reihenanordnung (28, 30) eines dritten Vorladerelais (28) und eines Vorladewiderstands (30) aufweist, die mit dem ersten Leistungsrelais (16) parallelgeschaltet ist, wobei das Verfahren aufweist:
• die Messung von zwei Spannungen (V₁, V₂) der Abschalt-/Anschlussvorrichtung (10);
• den Vergleich der gemessenen Spannungen (V₁, V₂) mit vorbestimmten Spannungswerten, die für Ausfälle der Abschalt- und Anschlussvorrichtung (10) repräsentativ sind; und
• die Diagnose eines Ausfalls eines Relais (16, 22, 28) abhängig vom Ergebnis des Vergleichs,
**dadurch gekennzeichnet, dass** die gemessenen Spannungen eine erste Spannung (V₁) zwischen der ersten Klemme (18) der Batterie (12) und der Klemme des zweiten Relais (22), die auf der Seite des Bordnetzes (14) angeordnet ist, und eine zweite Spannung (V₂) zwischen der ersten und der zweiten Klemme (20, 26) des Bordnetzes (14) sind.

2. Verfahren nach Anspruch 1, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das erste Relais einen durchgehend geschlossenen Zustand aufweist, wenn nach einem Öffnungsbefehl dieses Relais die ersten und zweiten gemessenen Spannungen im Wesentlichen gleich der Leerlaufspannung der Batterie sind.

3. Verfahren nach Anspruch 1 oder 2, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das zweite Relais einen durchgehend geschlossenen Zustand aufweist, wenn nach einem Öffnungsbefehl dieses Relais die erste gemessene Spannung im Wesentlichen gleich der Leerlaufspannung der Batterie und die zweite gemessene Spannung im Wesentlichen Null ist.

4. Verfahren nach Anspruch 1, 2 oder 3, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das dritte Relais einen durchgehend geschlossenen Zustand aufweist, wenn nach einem Öffnungsbefehl des ersten Relais die erste gemessene Spannung im Wesentlichen gleich der Leerlaufspannung der Batterie und die zweite Spannung positiv und niedriger als die Leerlaufspannung der Batterie ist.

5. Verfahren nach einem der vorhergehenden Ansprüche, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das erste Relais einen durchgehend offenen Zustand aufweist, wenn nach einem Öffnungsbefehl des dritten Relais die erste gemessene Spannung im Wesentlichen gleich der Leerlaufspannung der Batterie und wenn die zweite gemessene Spannung abnimmt.

6. Verfahren nach einem der vorhergehenden Ansprüche, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das dritte Relais einen durchgehend offenen Zustand aufweist, wenn nach einem Öffnungs- Schließbefehl dieses Relais die erste gemessene Spannung im Wesentlichen gleich der Leerlaufspannung der Batterie ist und wenn die zweite gemessene Spannung im wesentlichen Null ist.

7. Verfahren nach einem der vorhergehenden Ansprüche, **dadurch gekennzeichnet, dass** während der Nutzung des Fahrzeugs durch den Fahrer:
• der Anschluss der Batterie an das Bordnetz nacheinander aus dem Schließen des zweiten Relais, dem Schließen des dritten Relais, dem Schließen des ersten Relais und dem Öffnen des dritten Relais besteht;
• das Abschalten der Batterie vom Bordnetz nacheinander aus dem Öffnen des ersten Relais und dem Öffnen des zweiten Relais besteht,
und dass diagnostiziert wird, dass das zweite Relais einen durchgehend offenen Zustand aufweist oder diagnostiziert wird, dass die Klemmen der Batterie in offenem Stromkreis sind, wenn nach einem Schließbefehl des zweiten Relais die erste und die zweite gemessene Spannung im Wesentlichen Null sind.

8. Verfahren nach einem der vorhergehenden Ansprüche, **dadurch gekennzeichnet, dass** ein Wartungsablauf des Fahrzeugs nacheinander ausgehend von einem Parkmodus, in dem die ersten, zweiten und dritten Relais offen sind, aus dem Schließen des zweiten Relais, dem Schließen des dritten Relais, dem Schließen des ersten Relais, dem Öffnen des dritten Relais, dem Öffnen des ersten Relais und dem Öffnen des zweiten Relais besteht, und dass diagnostiziert wird, dass das zweite Relais durchgehend geschlossen ist, wenn im Parkmodus die erste gemessene Spannung im Wesentlichen gleich der Leerlaufspannung der Batterie und die zweite gemessene Spannung im Wesentlichen Null ist.

9. Verfahren nach einem der vorhergehenden Ansprüche, **dadurch gekennzeichnet, dass** ein Wartungsablauf des Fahrzeugs nacheinander ausgehend von einem Parkmodus, in dem die ersten, zweiten und dritten Relais offen sind, aus dem Schließen des zweiten Relais, dem Schließen des dritten Relais, dem Schließen des ersten Relais, dem Öffnen des dritten Relais, dem Öffnen des ersten Relais und dem Öffnen des zweiten Relais besteht, und dass diagnostiziert wird, dass das zweite Relais durchgehend offen ist, oder diagnostiziert wird, dass die Klemmen der Batterie in offenem Stromkreis sind, wenn nach einem Schließbefehl des zweiten Relais die ersten und zweiten gemessenen Spannungen im Wesentlichen Null sind.

10. Verfahren nach Anspruch 9, **dadurch gekennzeichnet, dass** es außerdem die Messung der Spannung an den Klemmen des zweiten Relais aufweist, um zu wissen, welche der Klemmen der Batterie oder des zweiten Relais in offenem Stromkreis ist.

11. Verfahren nach einem der vorhergehenden Ansprüche, **dadurch gekennzeichnet, dass** ein Wartungsablauf des Fahrzeugs nacheinander ausgehend von einem Parkmodus, in dem die ersten, zweiten und dritten Relais offen sind, aus dem Schließen des zweiten Relais, dem Schließen des dritten Relais, dem Schließen des ersten Relais, dem Öffnen des dritten Relais, dem Öffnen des ersten Relais und dem Öffnen des zweiten Relais besteht, und dass diagnostiziert wird, dass das dritte Relais durchgehend geschlossen ist, wenn nach einem Schließbefehl des zweiten Relais die erste gemessene Spannung im Wesentlichen gleich der Leerlaufspannung der Batterie ist, und die zweite gemessene Spannung bis zur Leerlaufspannung der Batterie zunimmt.

12. Verfahren nach einem der vorhergehenden Ansprüche, **dadurch gekennzeichnet, dass** ein Wartungsablauf des Fahrzeugs nacheinander ausgehend von einem Parkmodus, in dem die ersten, zweiten und dritten Relais offen sind, aus dem Schließen des zweiten Relais, dem Schließen des dritten Relais, dem Schließen des ersten Relais, dem Öffnen des dritten Relais, dem Öffnen des ersten Relais und dem Öffnen des zweiten Relais besteht, und dass diagnostiziert wird, dass das dritte Relais durchgehend offen ist, wenn nach einem Schließbefehl des dritten Relais die erste gemessene Spannung im Wesentlichen gleich der Leerlaufspannung der Batterie und die zweite gemessene Spannung im Wesentlichen Null ist.

13. Verfahren nach einem der vorhergehenden Ansprüche, **dadurch gekennzeichnet, dass** ein Wartungsablauf des Fahrzeugs nacheinander ausgehend von einem Parkmodus, in dem die ersten, zweiten und dritten Relais offen sind, aus dem Schließen des zweiten Relais, dem Schließen des dritten Relais, dem Schließen des ersten Relais, dem Öffnen des dritten Relais, dem Öffnen des ersten Relais und dem Öffnen des zweiten Relais besteht, und dass diagnostiziert wird, dass das erste Relais durchgehend offen ist, wenn nach einem Öffnungsbefehl des dritten Relais die erste gemessene Spannung im Wesentlichen gleich der Leerlaufspannung der Batterie ist, und die zweite gemessene Spannung abnimmt.

## Claims

1. Method for diagnosing the operating state of a device (10) for disconnection and connection of a bipolar high-voltage battery of accumulators (12) from/to a bipolar onboard power network (14) of an automobile vehicle, said device (10) comprising a first power relay (16) installed between a first terminal (18) of the battery (12) and a first terminal (20) of the power network (14), a second power relay (22) installed between a second terminal (24) of the battery (12) and a second terminal (26) of the power network (14), and a serial connection (28, 30) of a third pre-charging relay (28) and a pre-charging resistor (30), connected in parallel with the first power relay (16), said method comprising:
▪ the measurement of two voltages (V₁, V₂) on the disconnection and connection device (10);
▪ the comparison of the measured voltages (V₁, V₂) with predetermined values of voltage representative of faults in the disconnection and connection device (10); and
▪ the diagnosis of a fault in a relay (16, 22, 28) depending on the result of the comparison,
**characterized in that** the measured voltages are a first voltage (V₁) between the first terminal (18) of the battery (12) and the terminal of the second relay (22) installed on the onboard power network side (14) and a second voltage (V₂) between the first and second terminals (20, 26) of the onboard power network (14).

2. Method according to Claim 1, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the first relay is diagnosed as being in a continuously closed state if, after a command for opening the latter, the first and second measured voltages are substantially equal to the open-circuit voltage of the battery.

3. Method according to Claim 1 or 2, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the second relay is diagnosed as being in a continuously closed state if, after a command for opening the latter, the first measured voltage is substantially equal to the open-circuit voltage of the battery and the second measured voltage is substantially zero.

4. Method according to Claim 1, 2 or 3, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the third relay is diagnosed as being in a continuously closed state if, after a command for opening the first relay, the first measured voltage is substantially equal to the open-circuit voltage of the battery and the second voltage is positive and less than the open-circuit voltage of the battery.

5. Method according to any one of the preceding claims, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the first relay is diagnosed as being in a continuously open state if, after a command for opening the third relay, the first measured voltage is substantially equal to the open-circuit voltage of the battery and if the second measured voltage is decreasing.

6. Method according to any one of the preceding claims, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the third relay is diagnosed as being in a continuously open state if, after a command for opening for closing the latter relay, the first measured voltage is substantially equal to the open-circuit voltage of the battery and if the second measured voltage is substantially zero.

7. Method according to any one of the preceding claims, **characterized in that**, during the use of the vehicle by the driver:
▪ the connection of the battery to the onboard power network consists consecutively in the closing of the second relay, the closing of the third relay, the closing of the first relay and the opening of the third relay;
▪ the disconnection of the battery from the onboard power network consists consecutively in the opening of the first relay and the opening of the second relay,
and **in that** the second relay is diagnosed as being in a continuously open state or else the terminals of the battery are diagnosed as in open circuit if, after a command for closing the second relay, the first and the second measured voltages are substantially zero.

8. Method according to any one of the preceding claims, **characterized in that** a maintenance sequence for the vehicle consists consecutively, starting from a parking mode in which the first, second and third relays are open, in the closing of the second relay, the closing of the third relay, the closing of the first relay, the opening of the third relay, the opening of the first relay and the opening of the second relay, and **in that** the second relay is diagnosed as being continuously closed if, in parking mode, the first measured voltage is substantially equal to the open-circuit voltage of the battery and the second measured voltage is substantially zero.

9. Method according to any one of the preceding claims, **characterized in that** a maintenance sequence for the vehicle consists consecutively, starting from a parking mode in which the first, second and third relays are open, in the closing of the second relay, the closing of the third relay, the closing of the first relay, the opening of the third relay, the opening of the first relay and the opening of the second relay, and **in that** the second relay is diagnosed as being continuously open or else the terminals of the battery are diagnosed as being in open circuit if, after a command for closing the second relay, the first and second measured voltages are substantially zero.

10. Method according to Claim 9, **characterized in that** it furthermore comprises the measurement of the voltage across the terminals of the second relay in order to know which of the terminals of the battery or of the second relay are in open circuit.

11. Method according to any one of the preceding claims, **characterized in that** a maintenance sequence for the vehicle consists consecutively, starting from a parking mode in which the first, second and third relays are open, in the closing of the second relay, the closing of the third relay, the closing of the first relay, the opening of the third relay, the opening of the first relay and the opening of the second relay, and **in that** the third relay is diagnosed as being continuously closed if, after a command for closing the second relay, the first measured voltage is substantially equal to the open-circuit voltage of the battery and the second measured voltage increases up to the open-circuit voltage of the battery.

12. Method according to any one of the preceding claims, **characterized in that** a maintenance sequence for the vehicle consists consecutively, starting from a parking mode in which the first, second and third relays are open, in the closing of the second relay, the closing of the third relay, the closing of the first relay, the opening of the third relay, the opening of the first relay, and **in that** the third relay is diagnosed as being continuously open if, after a command for closing the third relay, the first measured voltage is substantially equal to the open-circuit voltage of the battery and the second measured voltage is substantially zero.

13. Method according to any one of the preceding claims, **characterized in that** a maintenance sequence for the vehicle consists consecutively, starting from a parking mode in which the first, second and third relays are open, in the closing of the second relay, the closing of the third relay, the closing of the first relay, the opening of the third relay, the opening of the first relay and the opening of the second relay, and **in that** the first relay is diagnosed as being continuously open if, after a command for opening the third relay, the first measured voltage is substantially equal to the open-circuit voltage of the battery and the second measured voltage is decreasing.
